# EUROPEAN PATENT APPLICATION

(11) **EP 1 326 242 A1**
(43) Date of publication of application: **09.07.2003**
(21) Application number: 01963403.9
(22) Date of filing: 30.08.2001
(51) Int. Cl.: G11B 7/24, G11B 11/105, G11B 7/26, C23C 14/34, C23C 14/06

(54) **REFLECTING LAYER, OPTICAL RECORDING MEDIUM AND SPUTTERING TARGET FOR FORMING REFLECTING LAYER**

(30) Priority: 04.09.2000 JP 2000267824
(71) Applicant: SONY CORPORATION, Tokyo 141 (JP)
(72) Inventor: Oda, Nobuhiro, c/o Furuya Metal Co., Ltd., Tokyo 170-0005 (JP); Ueno, Takashi, c/o Furuya Metal Co., Ltd., Tokyo 170-0005 (JP); Akimori, Toshihiro, c/o Sony Corporation, Tokyo 141-0001 (JP)
(74) Representative: Müller - Hoffmann & Partner
(86) International application number: JP0107494
(87) International publication number: WO02021524

(57) **Abstract**

The optical recording medium has a substrate (1) with a recording layer (2), a reflecting layer (3) and a protecting layer (4) laminated successively on the substrate (1). The reflecting layer (3) is a thin film of an alloy containing 99.7 to 73.0 % by weight of Cu as a major component, as well as, 0.2 to 18.0 % by weight of Ag and 0.1 to 9.0% by weight of Ti. The reflecting layer has a film thickness of 50 nm to 150 nm. The optical recording medium provided with the reflecting layer (3) shows improved corrosion resistance and also retains high reflectance. The present invention also provides a target for forming the reflecting layer (3).

## Description

### TECHNICAL FIELD

The present invention relates to a reflecting layer, an optical recording medium having a reflecting layer and a sputtering for forming a reflecting layer.

### BACKGROUND ART

Al and Al alloys are known as materials of reflecting layers in optical recording media. However, none of optical recording media having such reflecting layers are successful in giving sufficient reflectance.

Materials for giving high reflectance typically include Ag, Au and Cu. However, these materials involve the following problems.

Ag is highly reactive with other elements, so that Ag reflecting layers need to be improved in corrosion resistance. Further, Ag also acts not only upon chlorine which is contained in large amounts in recording layers or "dye stuff layers" composed of organic materials to be formed in CD-Rs but also upon other halogen atoms and compounds thereof and readily reacts with them. Thus, Ag is highly reactive with chlorine, sulfur, as well as, with compounds and ions thereof. In addition, Ag gives rise to problems in terms of weathering resistance. Ag reflecting layers suffer low reliability as those to be employed in optical recording media. Three kinds of organic materials, cyanine, phthalocyanine and azo series materials, are frequently used as major components of recording layers Improvement of corrosion resistance against those components which are contained in such organic materials is an issue in Ag reflecting layers and Al reflecting layers.

Because of its expensiveness, Au is not suitable for use as reflecting layers in optical recording media.

Cu is gaining attention as a material substituting for Ag and Au. However, Cu also has reactivity with other elements, although not so high as Ag does. Improvement of corrosion resistance is needed also in Cu reflecting layers. It is possible to employ alloys of Cu with other elements so as to lessen corrosion. However, such Cu alloys fail to exhibit high reflectance specific to Cu. Therefore, advent of a reflecting layer having both high reflectance and excellent corrosion resistance is being awaited.

It is an object of the present invention to provide a reflecting layer having high weathering resistance, an optical recording medium having the reflecting layer and a sputtering target for forming the reflecting layer.

It is another object of the present invention to provide a sputtering target for forming reflecting layers, which can improve various aspects including facility of manufacturing the alloy, stability in a sputtering process and ease of the sputtering process.

### DISCLOSURE OF THE INVENTION

The present invention includes a reflecting layer for an optical recording medium, comprising Cu, Ag and Ti, wherein Cu is contained in an amount of 99.7 to 73.0 wt %.

In one aspect, the reflecting layer contains Ag in an amount of 0.2 to 18.0 wt % and Ti in an amount of 0.1 to 9.0 wt %.

In another aspect, the reflecting layer has a film thickness of 50 nm to 150 nm.

The present invention also includes an optical recording medium having a disc-shaped substrate, a recording layer formed thereon, which permits laser recording of information, and the reflecting layer formed on the recording layer.

Further, the present invention includes a sputtering target comprising Cu, Ag and Ti, wherein Cu is contained in an amount of 99.7 to 73.0 wt %.

In one aspect, the sputtering target contains Ag in an amount of 0.2 to 18.0 wt % and Ti in an amount of 0.1 to 9.0 wt %.

### BRIEF DESCRIPTION OF THE DRAWINGS

Fig. 1 is a schematic cross-sectional view of the optical recording medium according to one embodiment of the present invention;
Fig. 2 is a graph showing the relationship between Ag concentration and Ti concentration;
Fig. 3 shows in an enlarged view a part of the graph in Fig. 2 showing the relationship between Ag concentration and Ti concentration; and
Fig. 4 is a graph showing the relationship between the film thickness of the reflecting film and RF-jitter.

### BEST MODE FOR CARRYING OUT THE INVENTION

The present invention will be described below more specifically by way of embodiments referring to the attached drawings.

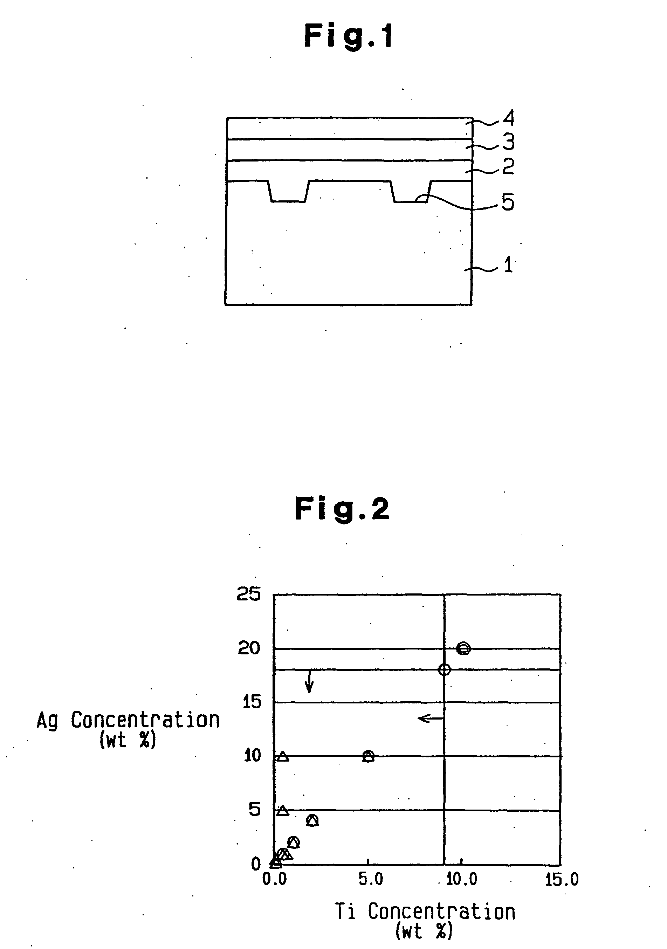

Fig. 1 shows a part of an optical disc (Compact Disc-Recordable, CD-R) as an optical recording medium. The optical disc has a substrate 1 on which a recording layer 2, a reflecting layer 3 and a protecting layer 4 are formed. The substrate 1 is made of a light-transmitting resin such as polycarbonate. The substrate 1 has a laser guide groove 5 formed on the surface thereof. The recording layer 2 contains an organic pigment. The protecting layer 4 is made, for example, of an acrylic ultraviolet curing resin.

The reflecting layer 3 is a thin alloy film containing Cu as a major component, Ag and Ti as a corrosion resistance improver. Ag and Ti interact with each other to improve corrosion resistance of the reflecting layer against chlorine, hydrogen, iodine, oxygen and sulfur, which is required for use in an atmospheric condition or in some particular ambiences.

The reflecting layer 3 has a film thickness of 50 to 150 nm. The reflecting layer 3 can be formed, for example, from a sputtering target by means of RF (AC) magnetron sputtering.

The atmospheric fusion or the vacuum fusion can be given as methods of forming the sputtering target of the present invention.

In the case of Cu alloy melting method, a base matrix alloy is prepared first. Next, Cu is admixed to the matrix alloy to adjust contents of the metals in the alloy such that the Cu content may be within the specified range.

In the case of the atmospheric fusion method, a Cu-X alloy is blended by means of arc melting in an Ar atmosphere (3.01 Pa. to 4.51 Pa.) to provide a matrix alloy. X is at least one element selected from Ti, Pd, Al, Au, Pt, Ta, Cr, Ni, Co, Si and Zn.

Next, Cu-X, Cu and Ag are melted at a predetermined ratio in a high-frequency melting furnace. Here, the quantity of Cu is the total amount of Cu minus the quantity of Cu contained in the matrix alloy. The melting temperature in the furnace is, for example, 1100 to 1800°C. The furnace is, for example, a crucible made of C, Al₂O₃, MgO or ZrO₂.

After the melt is fully fused, the resulting melt is left to stand for about one hour, and then the matrix alloy is added thereto, followed by fusing of the resulting mixture for 0.5 to 1 hour. An antioxidant is added to the mixture to control and prevent solution with oxygen contained in the melt. As the antioxidant, there can be used borax, sodium borate, lithium borate or carbon.

Next, the melt is charged into a Fe casting mold coated on the internal surface, for example, with alumina or Mg-containing talc. The Fe casting mold is preheated to about 300 to 500°C in an electric furnace before the melt is charged so as to prevent formation of shrinkage cavity.

The melt is cooled in the casting mold to be solidified to provide an ingot. The ingot is taken out of the casting mold and is cooled to ambient temperature. Next, the top or gate riser of the ingot is cut off, and the resulting ingot is rolled over a rolling machine to form-an alloy plate, for example, having dimensions of 90 (mm) x 90 (mm) x 8.1 (mm)

Subsequently, the alloy plate is subjected to heat treatment, for example, in an Ar-charged electric furnace at 400°C to 500°C for about 1 to 1.5 hours. Then, warp of the thus treated alloy plate is corrected over a pressing machine.

The thus corrected alloy plate is cut into the final product shape by means of wire cutting. The front surface of the resulting product is polished with a wet abrasive paper to adjust surface roughness of the product and provide finally a Cu alloy sputtering target of the present invention.

In the case where fusing is carried out by admixing Ag and other elements X to Cu in the method of manufacturing a Cu alloy sputtering target described above, the
conventional method can be applied likewise. This is very advantageous in terms of cost and process of manufacture.

### Sputtering conditions are as follows:

| | |
|---|---|
| Method | RF magnetron sputtering |
| Ultimate pressure | 4 x 10⁻³ (Pa) |
| Sputtering pressure | 0.76 (Pa) |
| Film forming power | 500 (W) |
| Sputtering gas | Ar |
| Atmospheric gas | Ar |
| Gas flow rate | 20 (standard cubic centimeter per minute, sccm) |

In Fig. 1, when information is recorded in a CD-R, a high-power laser beam is irradiated upon the recording layer 2. Then, the organic pigment contained in the recording layer 2 absorbs the laser beam to generate heat. This heat induces decomposition of the pigment and also deformation of the substrate 1 adjoining the recording layer 2 to reduce reflectance of the recorded portion. When the recorded information is reproduced, a laser beam of lower power than the recording laser beam is irradiated upon the recorded portion to reproduce the information utilizing the difference between the reflectance of the recorded portion and that of the unrecorded portion.

### Example 1

Next, properties of CD-R defined in Orange Book using a Cu-Ti-Ag alloy of this embodiment for the reflecting layer are shown. "Orange Book" is a physical format published by Philips and Sony defining significant properties of CD-R media. It should be noted here that Examples are given merely as illustrations, and results obtained herein shall not be appreciated to limit the kind of the target and that of the optical recording medium in the content of the present invention.

Conditions used in this example when the optical recording medium was produced are shown below.

Atmospheric temperature and humidity for coating treatment were controlled to be 25°C and 35 % respectively. The substrate 1 was formed from an injection molded polycarbonate resin to have a thickness of 1.2 mm and a diameter of 120 mm. The substrate 1 had a spiral guide groove 5. A pigment (1-butyl-[5-(1-butyl-3,3-dimethylbenz[e] indolin-2-ylidene)1,3-pentadienyl]-3,3-dimethyl-1H-benz[e]indolinium) having the molecular structure of Formula (I): 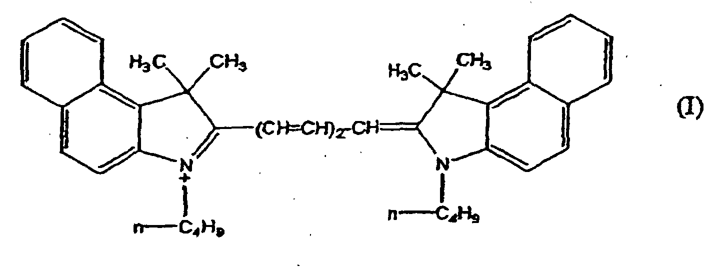 was dissolved in an organic solvent to prepare a pigment solution. The solution was applied to the center of the substrate surface having the guide groove by means of spin coating to form a recording layer 2. Then, a metal layer (reflecting layer 3) was formed by means of sputtering while changing as necessary the component ratio of the target, followed by formation of a protecting layer 4 in like atmosphere.

Subsequently, optical information was reproduced under room temperature condition with a linear velocity of 1.2 m/s with a 0.7 mW laser power to evaluate reflectance and corrosion resistance.

### 1. Reflectance measurement

CD-Rs were produced using various compositions of Cu-Ti-Ag alloys for forming reflecting layers respectively, and reflectance of each CD-R was measured. Compositions of the targets used for forming the CD-R samples used in the measurement and the results of measurement are as follows:

**Table 1**

| Cu composition (wt %) | Ti composition (wt %) | Ag composition (wt %) | Reflectance (%) |
|---|---|---|---|
| 85 | 5 | 10 | 69.1 |
| 73 | 9 | 18 | 65.0 |
| 70 | 10 | 20 | 63.9 |
| 94 | 2 | 4 | 72.1 |
| 97 | 1 | 2 | 72.9 |
| 98.5 | 0.5 | 1.0 | 73.9 |

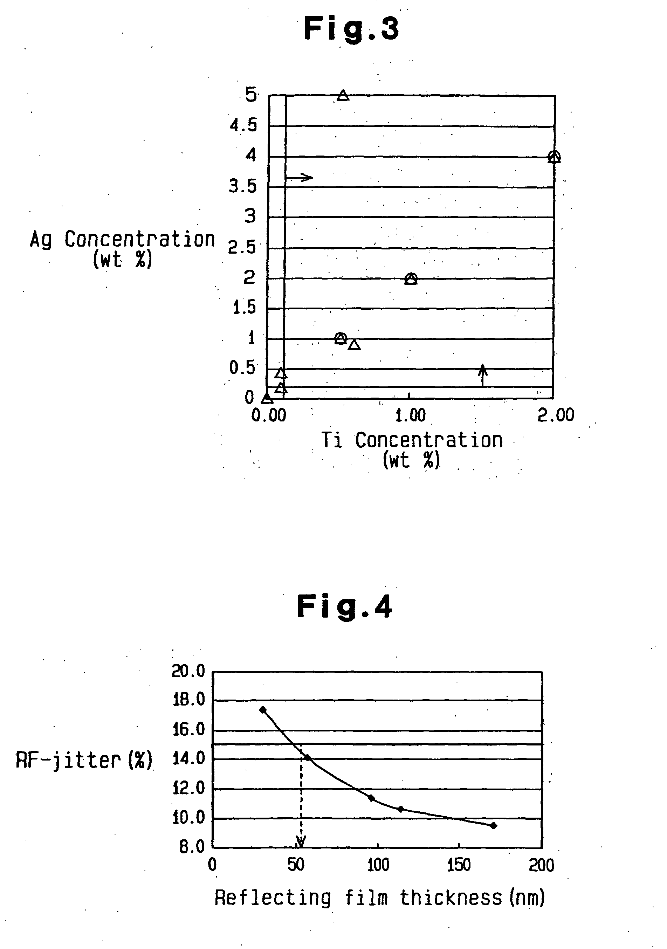

The relationship between component ratios of the samples is indicated by blanc circles in graphs of Figs. 2 and 3. Fig. 3 is an enlarged view showing a low Ti concentration region of the graph in Fig. 2.

It is required by standards that a CD-R have a reflectance of 65 % or more. As shown in Fig. 1 and Table 1, reflectance reduces with increase of the concentrations of the additional components Ti and Ag relative to Cu. In view of the effects of Ti and Ag added to Cu, a disc having a reflecting layer with the component ratio (Ti concentration: 9.0 wt % or less; Ag concentration: 18.0 wt % or less) defined in the present invention retains a high reflectance of 65 % or more, as shown in Fig. 2. It can be understood that the disc indicated by the double circle in Fig. 2, which is provided with a reflecting layer of a component ratio outside the range specified in the present invention, has a low reflectance of 65 % or less.

### 2. Evaluation of corrosion resistance

Cu-Ti-Ag alloy reflecting layers of various component ratios were formed to test corrosion resistance thereof. In order to find out more clearly the state of corrosion in the materials, various kinds of sample reflecting films were each prepared by laminating on a quartz glass substrate (40 mm x 20 mm) a reflecting film formed from a target of the composition as shown below to a thickness of 75 nm. Each sample reflecting film was immersed in brine (5 wt % NaCl) for 30 minutes to see if any reaction occurs or not. Compositions of the targets used for forming the sample reflecting films for the measurement are shown below together with the results of measurement.

**Table 2**

| Cu composition (wt %) | Ti composition (wt %) | Ag composition (wt %) | Reaction with brine |
|---|---|---|---|
| 85 | 5 | 10 | No |
| 94 | 2 | 4 | No |
| 97 | 1 | 2 | No |
| 98.5 | 0.6 | 0.9 | No |
| 89.5 | 0.5 | 10 | No |
| 94.5 | 0.5 | 5 | No |
| 98.5 | 0.5 | 1.0 | No |
| 98.9 | 0.2 | 0.9 | No |
| 99.45 | 0.1 | 0.45 | No |
| 99.7 | 0.1 | 0.2 | No |
| Pure Cu | | | Yes |

Component ratios of the samples showing the above results are indicated by triangles in Figs. 2 and 3. It can be understood from the above results that corrosion resistance improved by addition of Ti and Ag to pure Cu. In view of the effects of Ti and Ag added to Cu, in the cases where target materials having the component ratios (Ti concentration: 0.1 wt % or more; Ag concentration: 0.2 wt % or more) defined in the present invention were used, the reflecting films underwent no corrosion even under storage in brine which is rather a cruel condition but showed excellent corrosion resistance, as shown in Fig. 3. However, in the case of the reflecting film where a target material having a component ratio (Ti concentration: 0.0 wt %; Ag concentration: 0.0 wt % or more) outside the range specified in the present invention as indicated by the triangle at the lowest left end position in Fig. 3 is used, corrosion was observed in the reflecting layer, and it showed poor corrosion resistance. As can be understood from these two tests, the reflectance measurement and the evaluation of corrosion resistance, optical recording media formed by using Cu-Ti-Ag alloys (Cu: 99.7 to 73.0 wt %; Ti: 0.1 to 9.0 wt %; Ag: 0.2 to 18.0 wt %) each showed high reflectance while retaining excellent corrosion resistance. The above results evidently show effectiveness of the present invention.

### Example 2

In an organic optical recording medium, the reflecting layer serves as a heat sink material to influence properties of recording and reproducing signals, for example, RF-jitter. Thus, it becomes possible to manufacture media with excellent recording and reproducing signal characteristics by changing conditions for manufacturing recording media, for example, by changing the film thickness of the reflecting layer.

Meanwhile, it is known that recording and reproducing signals undergo no change when there is no temperature-dependent change in the properties of reflection. The reflecting layer materials of the present invention showed no change in thermal conductivity, so that it can be considered that the reflecting layers of the desired composition within the range specified in the present invention give like influences on the properties of recording and reproducing signals.

While the reflecting layer used in this embodiment had the component ratio Cu:Ag:Ti = 97:2:1, the component ratio is not to be limited to this due to the reason as described above.

In this embodiment, although CD-Rs compliant with Orange Book were used as typical organic optical recording media, the present invention shall not define the kind of optical recording medium including CD-R.

We focused attention on RF-jitter as characteristics of recording and reproducing signals. An RF signal of the light reflected from a recording medium for reproduction of information shows a waveform. An IC in a drive of a recording medium system generates a time span corresponding to a predetermined reference clock, and the recording-medium system operates based on this time span. RF-jitter is a value obtained by dividing the axial wavering of the waveform of the RF signal by the reference clock. If the jitter value is high, the drive makes false recognition of the data, so that the jitter value is desirably as proximate to zero as possible.

The recording medium in this embodiment was formed in the same manner as in Example 1.

A drive CRX-145E. (SONY Corporation) was used for recording and reproduction of information. Recording and reproduction in the recording medium were carried out at 8-time speed and at normal speed respectively. Recording was performed at a linear velocity of 1.2 m/s with a 11.0 mW laser power; reproduction was performed at a linear velocity of 1.2 m/s with a 0.7 mW laser power.

Signals were binarized and were subjected to measurement of jitter values over a jitter measuring instrument TA520 (Yokogawa Electric Corp.).

The results are summarized in Fig. 4 and Table 3.

**Table 3:**

| Correlation between film thickness of reflecting layer and RF-jitter value | |
|---|---|
| Film thickness (nm) | RF-jitter(%) |
| 30.5 | 17.4 |
| 57.0 | 14.1 |
| 95.7 | 11.4 |
| 115.0 | 10.7 |
| 172.0 | 9.6 |

It is standardized that CD-Rs have jitter values of 15 % or less.

As can be understood from the above results, according to the correlation curve shown in Fig. 4, the reflecting layer satisfied the RF-jitter value requirement of 15 % or less, when it has a film thickness of 50 nm or more.

This fact manifests significantly effectiveness of the present invention.

As described above, the reflecting layers of the present invention have high corrosion resistance and can give high-quality optical recording media which can prevent deterioration of reproducing signals over extended periods.

It should be apparent to those skilled in the art that the present invention may be embodied in many other specific forms without departing from the spirit or scope of the invention. Particularly, it should be understood that the invention may be embodied in the following forms.

While the reflecting layers described in the above embodiments were of Cu-Ti-Ag alloys containing Cu as a major component, Ag and Ti as a third element, the third element is not limited to Ti. The third element includes, for example, one or more elements selected from Pd, Al, Au, Pt, Ta, Cr, Ni, Co, Si and Zn.

The optical recording media are not limited to the CD-R as described in the above embodiments. The optical recording media may have additional layers, for example, a printing layer, a scratch preventing overcoat layer and a dielectric layer. Alternatively, one or two of the recording layer and protecting layer shown in Fig. 1 may be omitted. Further, the optical recording medium includes various kinds of optical recording media having metal thin films as the information layers such as optical discs, magneto-optical discs, phase change optical discs and card or sheet type recording media, having an information layer of one or more layers.

Therefore, the present examples and embodiments are to be considered as illustrative and not restrictive, and the invention is not to be limited to the details given herein, but may be modified within the scope of the appended claims and the equivalence.

### INDUSTRIAL. APPLICABILITY

As has been described heretofore, the target and the reflecting layer according to the present invention are effective for forming optical recording media having both high reflectance and high weathering resistance.

## Claims

1. A reflecting layer for an optical recording medium, the reflecting layer comprising:
Cu;
Ag; and
Ti,
wherein Cu is contained in an amount of 99.7 to 73.0 wt %.

2. The reflecting layer according to Claim 1, containing Ag in an amount of 0.2 to 18.0 wt % and Ti in an amount of 0.1 to 9.0 wt %.

3. The reflecting layer according to Claim 1, having a film thickness of 50 nm to 150 nm.

4. An optical recording medium, comprising:
a disc-shaped substrate;
a recording layer formed on the disc-shaped substrate, which permits laser recording of information; and
the reflecting layer as set forth in any of Claims 1 to 3 formed on the recording layer.

5. A sputtering target for forming a reflecting layer, the target comprising:
Cu;
Ag; and
Ti,
wherein Cu is contained in an amount of 99.7 to 73.0 wt %.

6. The sputtering target according to Claim 5, containing Ag in an amount of 0.2 to 18.0 wt % and Ti in an amount of 0.1 to 9.0 wt %.
